Europäisches Patentamt

European Patent Office

Office européen des brevets

(11) Publication number: **0 160 965**
**B1**

## EUROPEAN PATENT SPECIFICATION

(45) Date of publication of patent specification: **31.01.90**

(21) Application number: **85105571.5**

(22) Date of filing: **07.05.85**

(51) Int. Cl.⁵: **H 01 L 21/82, H 01 L 21/76, H 01 L 29/60, H 01 L 21/28, H 01 L 21/00**

(54) **Method of manufacturing a semiconductor device with a stacked-gate-electrode structure.**

(30) Priority: **07.05.84 JP 90414/84**
**13.07.84 JP 145336/84**

(43) Date of publication of application:
**13.11.85 Bulletin 85/46**

(45) Publication of the grant of the patent:
**31.01.90 Bulletin 90/05**

(84) Designated Contracting States:
**DE FR GB**

(56) References cited:
**GB-A-2 080 024**
**US-A-4 183 134**
**US-A-4 258 466**
**US-A-4 412 310**
**US-A-4 426 764**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Yoshikawa, Kuniyoshi c/o Patent Division**
**Kabushiki Kaisha Toshiba 1-1 Shibaura 1-chome**
**Minato-ku Tokyo 105 (JP)**
Inventor: **Sato, Masaki c/o Patent Division**
**Kabushiki Kaisha Toshiba 1-1 Shibaura 1-chome**
**Minato-ku Tokyo 105 (JP)**
Inventor: **Mori, Seiichi c/o Patent Division**
**Kabushiki Kaisha Toshiba 1-1 Shibaura 1-chome**
**Minato-ku Tokyo 105 (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

Courier Press, Leamington Spa, England.

## Description

This invention relates to a method of manufacturing a semiconductor device and, in particular, a method of manufacturing a semiconductor device having a stacked-gate-electrode structure.

An EPROM (Erasable Programmable Read Only Memory) includes a two-layered gate electrode structure: a floating gate and control gate. Conventionally, the floating gate is formed by etching a polycrystalline silicon layer which is formed on a first gate insulating film. In this connection it is to be noted that an opening is formed by an etching step in the polycrystalline silicon layer. At the same time, there occur cases where protruding ends are formed on the polycrystalline silicon layer. Thereafter, a conductive layer is so formed that it overlies the etched polycrystalline silicon layer with a second gate insulating film therebetween. In this way, a control gate is formed.

According to the conventional method, there occur cases where no such second gate insulating film of an adequate thickness is formed at the ends of the opening and thus the critical field strength of the second gate insulating film is lowered. Furthermore, if the end of the etched polycrystalline silicon layer protrudes, an electric field is concentrated there, thus lowering the critical field strength of the second gate insulating film. If the conductive layer is formed at the location of the opening, there is disadvantage that a breakage occurs at the stepped portion of the opening. This phenomenon prominently occurs if the conductive layer, in particular, is formed of, for example, a metal layer having a high melting point, a layer of a silicide of the metal having high melting point or a polycide layer (i.e., a two-layered structure comprised of a polycrystalline silicon layer and a layer of a silicide of the metal having a high melting point).

U.S. Patent No, 4,412,310 to George J. Korsh et al. discloses the process of forming an oxide layer between a floating gate and an overlying control gate, in which the oxide layer is thicker at the edges of the floating gate than in the central portion thereof. According to this invention, however, the above-mentioned problem is solved by another method.

It is accordingly an object of this invention to provide a method of manufacturing a semiconductor device with a stacked-gate-electrode structure which can improve a critical field strength between the gate electrodes and can prevent a possible breakage in the stepped portion of two or more gate electrodes.

To attain the object of this invention, there is provided a method of manufacturing a semiconductor device according to claim 1 comprising the steps of forming a floating gate such that it overlies a semiconductor substrate with an insulating film formed between the floating gate and the substrate forming a control gate such that it overlies the floating gate with an insulating film formed between the control gate and the floating gate, and forming source and drain regions in the semiconductor substrate in a spaced-apart relation, characterized by comprising the steps of forming an oxidation-resistant film pattern having a predetermined opening over a non-monocrystalline silicon layer, and forming a floating gate by selectively oxidizing the non-monocrystalline silicon layer in the predetermined opening with the oxidation-resistant film pattern as a mask to form a separation insulating film with a portion of the non-monocrystalline silicon layer.

The specific arrangement of the semiconductor device permits the end of the floating gate to be smoothly formed through the selective oxidation and thus prevents an electric field from being concentrated toward the end of the floating gate. Furthermore, the non-monocrystalline silicon layer is selectively oxidized to form a floating gate with a part of the non-monocrystalline silicon layer insulatingly separated. This specific arrangement prevents the thickness of a control gate formation layer from reducing at its stepped area and thus prevents a possible breakage at the stepped portion of the control gate formation layer.

If the oxidation-resistant film pattern of, for example, $Si_3N_4$, which has been used as a mask, is also used as a gate insulating film, it is possible to improve the critical field strength of the gate insulating film.

The other objects and advantages will be apparent from the following description taken in conjunction with the accompanying drawings in which:

Figs. 1A through 1E are cross-sectional views for explaining a method of manufacturing a semiconductor device according to a first embodiment of this invention;

Fig. 2 is a plan view showing the semiconductor device manufactured by the first embodiment as shown in Figs. 1A through 1E;

Fig. 3 is a cross-sectional view as taken along line III—III in Fig. 2;

Fig. 4 is a plan view showing a semiconductor device for explaining an important problem, which a second embodiment of this invention should solve;

Figs. 5A to 5E are cross-sectional views for explaining a method for manufacturing a semiconductor device according to a second embodiment of this invention;

Fig. 6 is a cross-sectional view showing a substrate structure for explaining a modified form (a second embodiment) of a semiconductor device;

Fig. 7 is a plan view showing a semiconductor device manufactured by the second embodiment of this invention;

Figs. 8A to 8E are cross-sectional views for explaining a method of manufacturing a semiconductor device according to a third embodiment of this invention;

Fig. 9 is a plan view showing a semiconductor device manufactured by the third embodiment of this invention; and

Fig. 10 is a cross-sectional view taken along line X—X in Fig. 9.

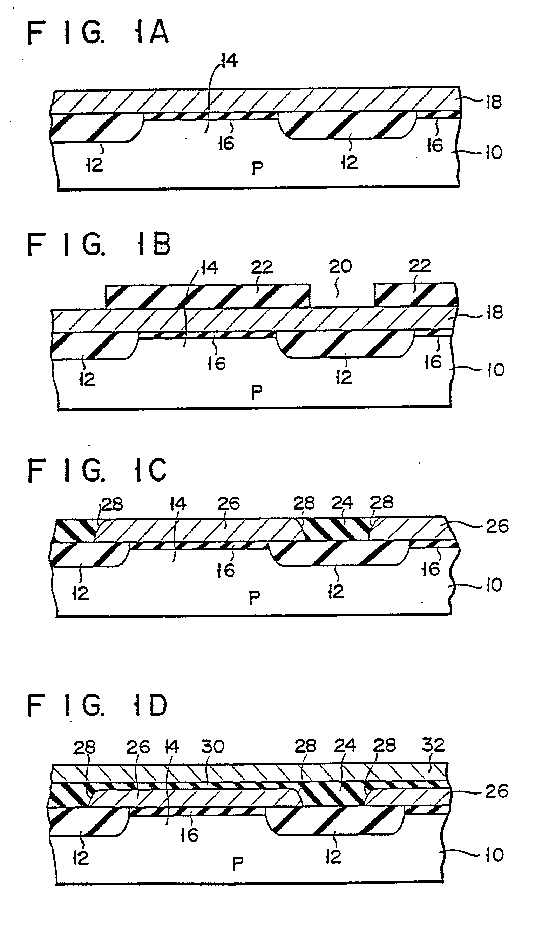

A semiconductor device according to a first embodiment of this invention will be explained below by referring to Figs. 1A through 1E and Figs. 2 and 3.

As shown in Fig. 1A, for example, an element separation area 12 is formed by a well known method on the surface portion of a p-type silicon substrate 10 and a first gate insulating film 16 is formed on a channel region in an island region 14 which is surrounded by this element separation area 12. It is preferred that the element separation area 12 be buried in the silicon substrate 10 and planarized. Then, a first polycrystalline silicon layer 18 is formed by, for example, a low-pressure chemical vapor deposition on the whole surface of the resultant structure. Then, an impurity, such as phosphorus, is heavily doped into the first polycrystalline silicone layer 18 with a high concentration of $3\times10^{20}$ to $8\times10^{20}$/cm³. This doping step is carried out by heat-treating the first polycrystalline silicon layer 18 in a POCl₃ atmosphere for 30 to 70 minutes at 900° to 950°C.

As shown in Fig. 1B, a silicon nitride film is deposited on the whole surface of the resultant structure and the silicon nitride film on the portion of the element separation area 12 is selectively etched by a photolithography and an RIE (Reactive Ion Etching) method to form a silicon nitride film pattern 22 having an opening 20. It is preferable, but not necessary, that a thin oxide film, for example, be formed between the first polycrystalline silicon layer 18 and the silicon nitride film pattern 22.

Then, as shown in Fig. 1C, the first polycrystalline silicon layer 18 is thermally oxidized in a H₂-burning atmosphere at 950°C to 1100°C. At this time, the thermal oxidation is carried out under the condition that the first polycrystalline silicon layer 18 is completely oxidized below the opening 20 of the silicon nitride pattern 22. As a result, the first polycrystalline silicon layer 18 below the opening 20 of the silicon nitride pattern 22 is completely oxidized to provide a silicon oxide film 24 as a separation insulating film. A first polycrystalline silicon layer pattern 26 left below the silicon nitride film pattern 22 without being oxidized serves as a floating gate. The end 28 of the first polycrystalline silicon layer pattern 26, which contacts with the silicon oxide film 24, is thus processed to have a smooth, convex face. In other words, the end 28 is not protruded. Thereafter, the silicon nitride film pattern 22 is removed either with a heated phosphoric acid or by a plasma etching method.

As shown in Fig. 1D, a silicon oxide film 30 is formed on the surface of the first polycrystalline silicon layer pattern 26 and then a second polycrystalline silicon layer 32 is deposited on the surface of the resultant structure. An impurity is introduced into the second polycrystalline silicon layer 32. In order to obtain a peripheral transistor (not shown) having a one-layer gate structure other than a memory cell transistor having a two-layered gate structure, the second polycrystalline silicon layer 32 is selectively removed to expose the first polycrystalline silicon layer pattern 26, noting that the second polycrystalline silicon layer 32 is exposed at the location of the memory cell.

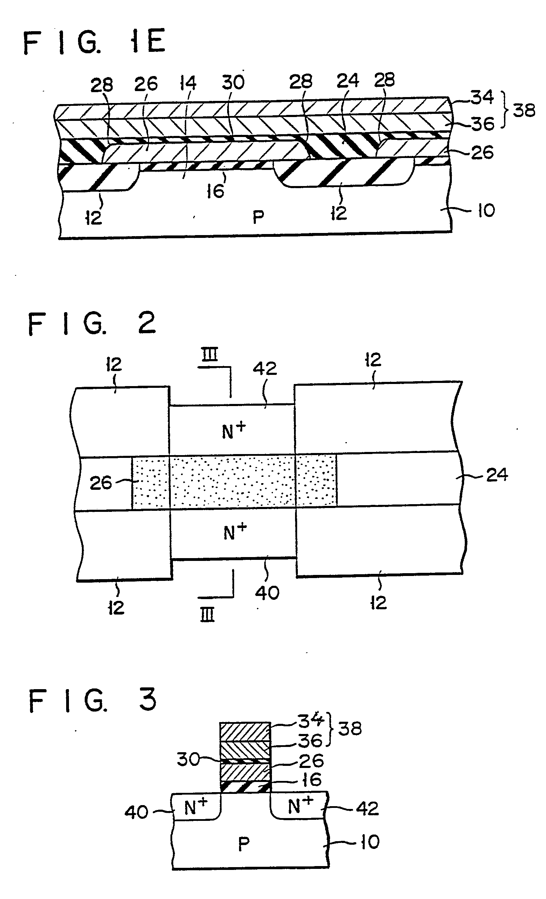

Then, as shown in Fig. 1E, for example, a molybdenum silicide layer is formed by a sputtering method on the whole surface of the resultant structure and subjected to a patterning step to form a molybdenum silicide layer pattern 34 and second polycrystalline silicon layer pattern 36. These layer patterns 34 and 36 provide a control gate 38, noting that the control gate 38 should include at least one layer of a metal having a high melting point or a silicide of the metal having a high melting point.

Then, as shown in Figs. 2 and 3, with the control gate 38 as a mask, n-type impurity ions are implanted into the silicon substrate 10 to form N⁺ source and drain regions 40 and 42. The dotted region in Fig. 2 represents the first polycrystalline silicon layer pattern, i.e., the floating gate 26. An insulating film, though not shown, is formed on the whole surface of the resultant structure and then an opening is formed, as a contact hole, in the insulating film overlying the source and drain regions 40 and 42 and control gate 38, and so on. An Al interconnection layer is formed at the location of the contact hole to complete an EPROM.

According to this embodiment, since the first polycrystalline silicon layer 18 at the location of the opening 20 is completely oxidized with the silicon nitride film pattern 22 as a mask, the remaining first polycrystalline silicon layer pattern 26 provides a floating gate electrode and at the same time the end 28 of the floating gate 26 contacting with the silicon oxide film 24 is formed to have a smooth, convex face. This arrangement can prevent a breakage at a stepped portion of the control gate and a concentrated electric field, resulting from the formation of the floating gate by the RIE method.

On the other hand, in the conventional steps of continuously etching the molybdenum silicide layer pattern 34, second polycrystalline silicon pattern 36 and first polycrystalline silicon pattern 26 and eventually forming a word line and floating gate, use is made of an ordinary RIE method. In this case, the metal layer having a high melting point, silicide layer or polycide layer has a lower etching selectively for SiO₂ than for the polycrystalline silicon layer and, at this etching step, it also takes a longer overetching time to reach the word line layer at the stepped portion. In consequence, upon etching the molybdenum silicide layer pattern 34 and second polycrystalline silicon pattern 36 within the opening, the surface portion of the underlying field isolation region made of SiO₂ is also etched, presenting a possibility that the critical field strength of the field isolation region may be lowered.

According to this invention, however, since the molybdenum silicide layer pattern 34 and second polycrystalline silicon layer pattern 36 are planarized, there is no risk that the field insulating film 12 ($SiO_2$) may be overetched when a stripelike control gate is formed by the RIE method. It is therefore possible having tendency to lower the critical field strength of the field region.

As the control gate 38 is comprised of the molybdenum silicide layer pattern 34 and second polycrystalline silicon layer pattern 36, it is possible to obtain a high-speed unit as compared with the conventional control gate made of a polycrystalline silicon layer. It is to be noted that, even if the polycide structure was used as a control gate, it is not possible to obtain a high-speed unit when a breakage is present at the stepped portion of the control gate. According to this invention, it is possible to attain a high-speed unit through the use of the control gate of the polycide structure since no breakage occurs at the stepped portion of the control gate.

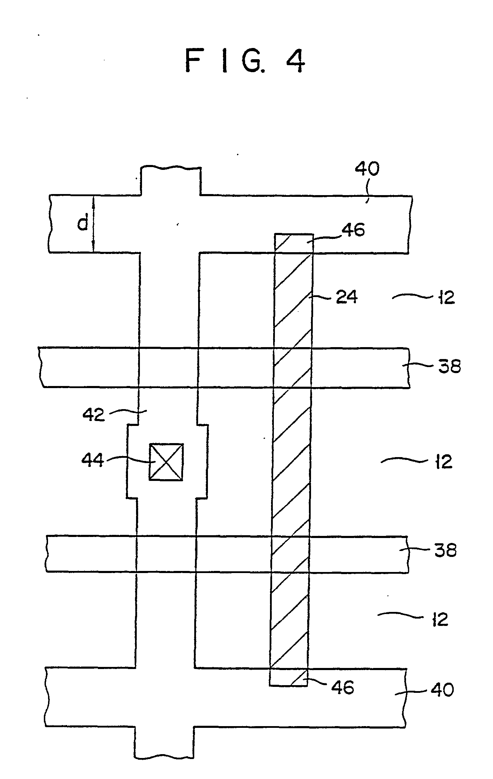

The manufacture of an EPROM will be explained below in connection with a second embodiment of this invention by referring to Figs. 4, 5A to 5E, 6 and 7 jointly.

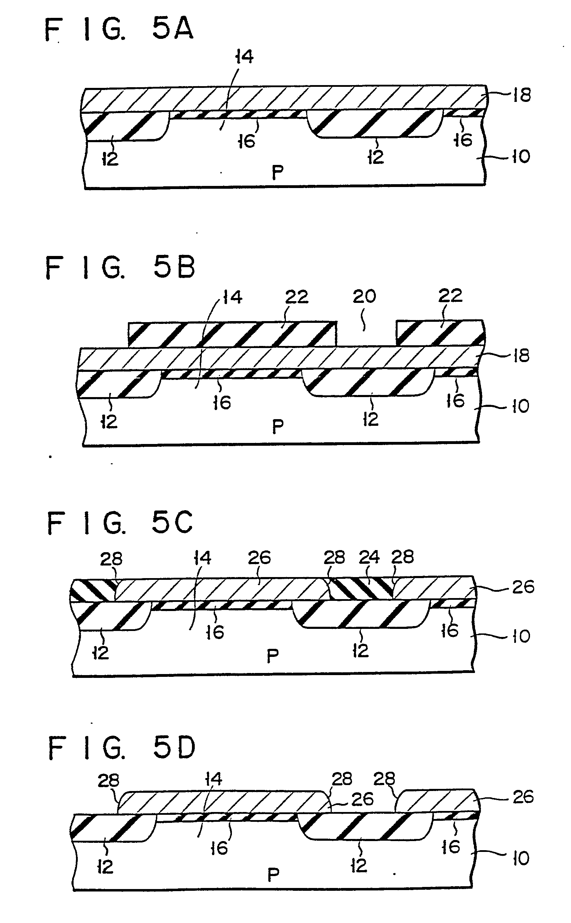

A silicon oxide film 24 which is formed by oxidizing the first polycrystalline silicon layer 18 should be formed only on a field isolation area 12, taking a possible ordinary error into consideration. The silicon oxide film, as indicated by a shaded section in Fig. 4, should not be so formed as to extend overlappingly over a source region (diffusion region) 40 as indicated at a projection 46 in Fig. 4. This is because, when the silicon oxide film 24 extends overlappingly over the source region 40 as the projection 46, the width d of the source region 40 is partially narrowed, this increasing a diffusion layer resistance. As a result, the source potential of the memory cell tends to vary. If the overlapped portion or projection 46 of the silicon oxide film 24 is not allowed, a much greater distance is required between the control gate 38 and the source region 40, eventually lowering the packing density of the memory cell. In Fig. 4, reference numeral 44 shows a contact portion of a drain region 42. In order to solve the above-mentioned problem, it is only necessary to manufacture an EPROM in accordance with the method as shown in Figs. 5A to 5E.

As shown in Fig. 5A, the element separation region 12 and first gate insulating film 16 are formed on the surface portion of a p-type silicon substrate 10 and a first polycrystalline silicon layer 18 is formed on the resultant structure. Like the first embodiment of this invention, phosphorus is heavily doped into the first polycrystalline silicon layer 18. A silicon substrate portion surrounded by the element separation area 12 provides an element formation area or an island region 14. As shown in Fig. 5B, a silicon nitride film pattern 22 having a predetermined opening is formed on the first polycrystalline silicon layer 18. As shown in Fig. 5C, with the silicon nitride film pattern 22 as a mask the first polycrystalline layer 18 is selectively oxidized to form a silicon oxide film 24 and first polycrystalline silicon layer pattern 26 (floating gate). Then, the silicon nitride film pattern is removed.

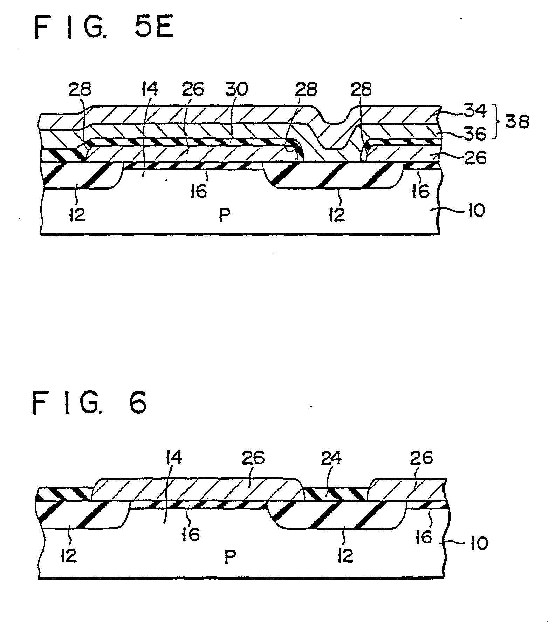

Then, the silicon oxide film 24 is removed as shown in Fig. 5D. A silicon oxide film 30 is formed on the surface of the first polycrystalline silicon layer pattern 26 as shown in Fig. 5E and a control gate 38 comprised of a polycrystalline silicon pattern 36 and molybdenum silicide pattern 34 is formed on the surface of the resultant structure as shown in Fig. 5E. Like the first embodiment, with the control gate 38 as a mask, $N^+$ type source and drain regions 40 and 42 are formed in the surface portion of the silicon substrate 10 and an insulating film is formed on the surface of the resultant structure. An opening is formed in the insulating film on the source and drain regions 40 and 42 to provide a contact hole. An Al interconnection layer is formed over the contact hole to obtain an EPROM (see Figs. 2 and 3).

Instead of removing all the silicon oxide film 24 as shown in Fig. 5D, the projection 46 (see Fig. 4) of the silicon oxide film 24 extending over a diffusion region, such as the source region 40, may be partially removed from the element separation area 12, using a mask alignment technique (not shown). As shown in Fig. 6, the silicon oxide film 24 may be removed, without using the mask, so as to leave a portion of some thickness at the overlapped portion 46, which portion is all etched away at a later step of treating the silicon substrate surface.

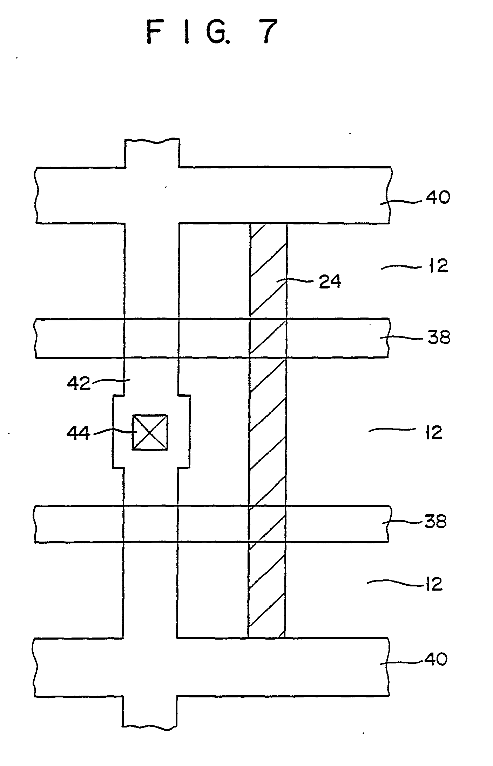

In the manufacturing method according to the second embodiment of this invention, the selective oxidation is effected, as in the first embodiment, with the silicon nitride film pattern 22 as a mask and, in consequence, the end 28 of the floating gate 26 contacting with the silicon oxide film 24 can be formed to have a smooth, convex face. As a result, it is possible to improve the critical field strength of the gate insulating film 30 between the floating gate 26 and the control gate 38 and thus to prevent a breakage at the stepped portion of the control gate 38. As the control gate 38 is comprised of the molybdenum silicide layer pattern 34 and polycrystalline silicon layer pattern 36, a high speed element can be obtained as compared with the conventional control gate which is comprised of only a polycrystalline silicon layer. After the silicon oxide film 24 has been formed, the overlapped portion 46 of the silicon oxide film 24 overlappingly extending over the source region 40 in the element region 14 from the elements separation area is removed to obtain an arrangement as shown in Fig. 7. The packing density of the memory cell can be further improved without involving a potential variation in the source region 40. The same advantage can also be obtained even if the control gate 38 is made of a polycrystalline or amorphous silicon.

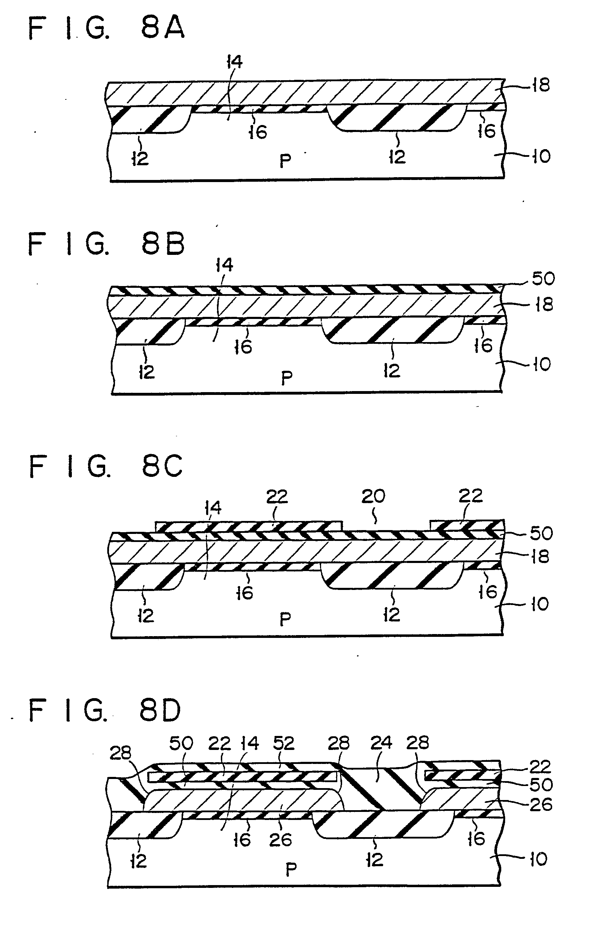

The method of manufacturing an EPROM according to a third embodiment of this invention will be explained below by referring to Figs. 8A to 8E, 9 and 10.

As shown in Fig. 8A, an element separation area 12 is formed by a well known technique on the surface portion of a p-type silicon substrate 10 and a first gate insulating film 16 is formed by, for example, a thermal oxidation method on an island region 14 of the silicon substrate 10 which is surrounded by the element separation area 12. Then, a first polycrystalline silicon layer 18 made of non-monocrystalline silicon is deposited, with a thickness of, for example, 0.2 µm (2000 Å), on the whole surface of the resultant structure and then the silicon layer 18 is heavily doped either by an ion implantation method using phosphorus as an impurity or by a thermal diffusion method using a POCl₃ as a diffusion source, to attain a high concentration level of $3\times10^{20}$ to $8\times10^{20}$/cm³. In the thermal diffusion method, heat treatment can be effected in the POCl₃ atmosphere for 30 to 70 minutes at 900°C to 950°C.

Then, as shown in Fig. 8B, a first silicon oxide film 50 about 20 nm (200 Å) thick is formed on a first polycrystalline silicon layer 18 by adopting a dilution oxidation method at a temperature of, for example, 900°C to 1100°C. Then, as shown in Fig. 8C, a silicon nitride film about 15 nm (150 Å) thick is formed on the whole surface of the resultant structure by an LPCVD (Low Pressure Chemical Vapor Deposition) or a plasma CVD method and the silicon nitride film portion overlying a predetermined portion of the element separation area 12 is selectively removed by a photolithography and a RIE method to obtain a silicon nitride film pattern 22 having an opening 20.

Then, as shown in Fig. 8D, a thermal oxidation step is carried out with a silicon nitride film pattern 22 as a mask, under the condition that the portion of the first polycrystalline silicon layer 18 within the opening 20 of the silicon nitride film pattern 22 is completely oxidized. As a result, the first polycrystalline silicon layer portion below the opening 20 of the silicon nitride pattern 22 is thermally oxidized to provide a second silicon oxide film 24 and a third silicon oxide film 52 on the silicon nitride film pattern 22. In this way, the whole surface of the silicon substrate 10 is substantially planarized. The remaining unoxidized first polycrystalline silicon layer 18 provides a first polycrystalline silicon layer pattern 26 as a floating gate with its end 28 smoothly and convexly formed.

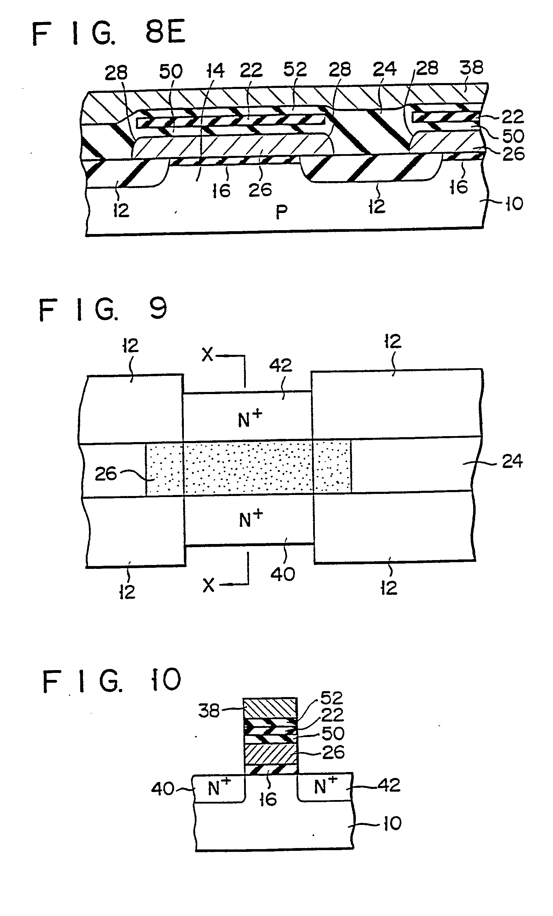

As shown in Fig. 8E, a second polycrystalline silicon layer is deposited on the whole surface of the resultant structure and, after being subjected to a patterning step, provides a control gate 38. Then, with the control gate as a mask an n-type impurity is ion-implanted into the silicon substrate 10 to provide N⁺ type source and drain regions 40 and 42. An insulating film, though not shown, is formed on the whole surface of the resultant structure and the portions of the insulating film overlying the source and drain regions 40 and 42 are opened to provide corresponding contact holes over which an Al interconnection layer is formed. In this way, an EPROM is fabricated for which reference is invited to Figs. 9 and 10.

According to this embodiment, since the first polycrystalline silicon layer pattern 26 (left unoxidized at the step of the selective oxidation of the first polycrystalline silicon layer 18) provides the floating gate and since the second silicon oxide film 24 is formed over the opening 20 and the third silicon oxide film 52 is formed on the silicon nitride film pattern 22, it is possible to substantially planarize the whole surface of the device. This specific arrangement can overcome a problem, that is, a reduction in critical field strength between the control gate and the floating gate which may be involved in the conventional method of forming the floating gate by the RIE step. Furthermore, the end 28 of the first polycrystalline silicon layer pattern 26 is smoothly formed, preventing an electric field from being concentrated there. The three-layered insulating film structure, that is, the first silicon oxide film 50, silicon nitride film pattern 22 and third silicon oxide film 52 are formed between the floating gate 26 and the control gate 38 with the result that the silicon nitride film pattern 22 deposited alleviates a nonuniformity in the film thickness of the first silicon oxide film 50 and has its own high critical field strength. It is therefore possible to improve the critical field strength of the gate insulating film between the floating gate 26 and the control gate 38. It is also possible to obtain a greater capacitance between the floating gate 26 and the control gate 38 due to the presence of the silicon nitride film pattern 22 of a high electric constant or permittivity.

This embodiment can be modified as follows. The control gate 38 may be formed of a metal layer, metal silicide layer or polycide layer, having high melting points. In this case, the whole surface of the semiconductor device can be substantially planarized, prominently avoiding any possible breakage in the stepped portion of the control gate.

As a gate insulating film between the floating gate 26 and the control gate 38 use may be made of a silicon nitride film pattern 22 only, or a two-layered structure comprised of the silicon oxide film (50 or 53) and silicon nitride film pattern. The floating gate is not restricted to the polycrystalline silicon layer and may be formed of an amorphous semiconductor layer.

Although this embodiment has been explained as being applied to the EPROM, it is not restricted thereto. This invention is also applicable to the manufacture of a semiconductor device having two or more gate electrodes.

**Claims**

1. A method of manufacturing a semiconductor device comprising the steps of forming a floating gate (26) overlying a semiconductor substrate with a gate insulating film (16) formed between the floating gate and the substrate forming a control gate (38) overlying the floating gate with an insulating film formed therebetween and, forming source and drain regions (40, 42) in the semiconductor substrate (10) in a spaced-apart relation, characterized by comprising the steps of:

forming an oxidation-resistant film pattern (22) having a predetermined opening (20) over a non-monocrystalline silicon layer (18); and

forming a floating gate layer (26) by selectively oxidizing the non-monocrystalline silicon layer (18) within the predetermined opening (20) with the oxidation-resistant film pattern as a mask to form a separation insulating film (24) whereby a portion of the non-monocrystalline silicon layer is insulatingly separated and a floating gate layer portion (28) adjacent to the separation insulating film (24) is formed to have a smooth, convex face.

2. A method according to claim 1, characterized in that said oxidation-resistant film pattern is so formed that it overlies the non-monocrystalline silicon layer with an insulating film (50) therebetween.

3. A method according to claim 1 or 2, characterized in that an impurity is heavily doped into the non-monocrystalline silicon layer before the non-monocrystalline silicon layer is selectively oxidized.

4. A method according to claim 3, characterized in that said impurity is doped with a high concentration level of phosphorus of the order of $3 \times 10^{20}$ to $8 \times 10^{20}/cm^3$.

5. A method according to any one of the preceding claims, characterized in that, after the floating gate layer (26) has been formed, a control gate (38) is so formed that it overlies said floating gate layer with the insulating film (50, 22, 52) therebetween, said control gate (38) being made of a metal having a high melting point or a silicide of said metal.

6. A method according to claim 1, 2, 3 or 4, characterized in that, after the floating gate layer has been formed, a control gate layer (34, 36, 38) made of a polycide is formed such that it overlies the floating gate layer with the insulating film therebetween.

7. A method according to any one of the preceding claims, characterized in that, after said separation insulating film (24) has been formed, a part or a whole of said separation insulating layer (24) is removed.

8. A method according to claim 1, 2, 3 or 4, characterized in that with said oxidation-resistant pattern (22) left over the floating gate and with said separation insulating film (24) left within the opening, a control gate layer (38) is formed on the resultant structure.

9. A method according to any one of the preceding claims, characterized in that said oxidation-resistant film pattern (22) is a silicon nitride film.

10. A method according to any one of the preceding claims, characterized in that said non-monocrystalline silicon layer is made of a polycrystalline silicon or an amorphous silicon.

## Patentansprüche

1. Verfahren zum Herstellen einer Halbleiteranordnung, enthaltend die folgenden Schritte:
—Bilden eines schwebenden Gate (26), das über einem Halbleitersubstrat mit einem zwischen dem schwebenden Gate und dem Substrat gebildeten Gateisolierfilm (16) liegt,
—Bilden eines Steuergate (38), das über dem schwebenden Gate mit einem dazwischen gebildeten Isolierfilm liegt und
—Bilden von Quellen- und Senkenbereichen (40, 42) in dem Halbleitersubstrat (10) mit Abstand zueinander,
gekennzeichnet durch die folgenden Schritte:
—Bilden eines oxidationswiderstandsfähigen Musters (22) mit einer vorbestimmten Öffnung (20) über einer nicht-monokristallinen Siliziumschicht (18); und
—Bilden einer schwebenden Gate-Schicht (26) durch selektives Oxidieren der nicht-monokristallinen Siliziumschicht (18) innerhalb der vorbestimmten Öffnung (20) unter Verwendung des oxidationswiderstandsfähigen Filmmusters als Maske, um einen Trennisolierfilm (24) zu bilden, womit ein Teil der nicht-monokristallinen Siliziumschicht isolierend getrennt und ein schwebendes Gate-Schichtteil (28) angrenzend an den Trennisolierfilm (24) mit einer glatten gewölbten Stirnfläche gebildet wird.

2. Verfahren nach Anspruch 1, dadurch gekennzeichnet, daß das oxidationswiderstandsfähige Filmmuster derart gebildet wird, daß es über der nicht-monokristallinen Siliziumschicht mit einem Isolierfilm (15) dazwischen liegt.

3. Verfahren nach Anspruch 1 oder 2, dadurch gekennzeichnet, daß ein Störstoff in die nicht-monokristalline Siliziumschicht hoch dotiert wird, bevor die nicht-monokristalline Siliziumschicht selektiv oxidiert wird.

4. Verfahren nach Anspruch 3, dadurch gekennzeichnet, daß der Störstoff mit einem hohen Konzentrationspegel von Phosphor in dem Bereich $3 \times 10^{20}$ bis $8 \times 10^{20}/cm^3$ dotiert wird.

5. Verfahren nach einem der vorhergehenden Ansprüche, dadurch gekennzeichnet, daß, nachdem die schwebende Gate-Schicht (26) gebildet worden ist, ein Steuergate (38) derart gebildet wird, daß es über der schwebenden Gate-Schicht mit einem Isolierfilm (50, 22, 52) dazwischen gebildet wird, wobei das Steuergate (38) aus einem Metall mit einem hohen Schmelzpunkt oder einem Silizid des Metalls hergestellt wird.

6. Verfahren nach Anspruch 1, 2, 3 oder 4, dadurch gekennzeichnet, daß, nachdem die schwebende Gate-Schicht gebildet worden ist, eine Steuergateschicht (34, 36, 38) aus einem Polyzid derart gebildet wird, so daß sie über der schwebenden Gate-Schicht mit einem Isolierfilm dazwischen gebildet wird.

7. Verfahren nach einem der vorhergehenden Ansprüche, dadurch gekennzeichnet, daß, nachdem der Trennisolierfilm (24) gebildet worden ist, ein Teil oder eine Gesamtheit des Trennisolierfilms (24) entfernt wird.

8. Verfahren nach Anspruch 1, 2, 3 oder 4, dadurch gekennzeichnet, daß eine Steuergateschicht (38) mit dem über dem schwebenden Gate übriggebliebenen oxidationswiderstandsfähigen Muster (22) und mit dem innerhalb der Öffnung übriggebliebenen Trennisolierfilm (24) auf der resultierenden Struktur gebildet wird.

9. Verfahren nach einem der vorhergehenden Ansprüche, dadurch gekennzeichnet, daß das oxidationswiderstandsfähige Filmmuster (22) ein Siliziumnitridfilm ist.

10. Verfahren nach einem der vorhergehenden Ansprüche, dadurch gekennzeichnet, daß die nicht-monokristalline Siliziumschicht aus einem polykristallinen Silizium oder einem amorphen Silizium hergestellt wird.

**Revendications**

1. Un procédé de fabrication d'un dispositif à semiconducteur comprenant les étapes de formation d'une grille flottante (26) par-dessus un substrat semi-conducteur avec un film d'isolation de grille (16) formé entre la grille flottante et le substrat, formation d'une grille de contrôle (38) par-dessus la grille flottante avec un film d'isolation formé entre les deux et formation de régions de source et de drain (40, 42) dans le substrat semi-conducteur (10), écartées l'une de l'autre, caractérisé en ce qu'il comporte les étapes suivantes:

formation d'un film résistant à l'oxydation à motif (22) ayant une ouverture prédéterminée (20) sur une couche de silicium non monocristallin (18); et

formation d'une couche de grille flottante (26) par oxydation sélective de la couche de silicium non monocristallin (18) à l'intérieur de l'ouverture prédéterminée (20) avec le film résistant à l'oxydation à motif comme un masque pour former un film isolant de séparation (24) de sorte qu'une portion de la couche de silicium non monocristallin est séparée de façon isolante et qu'une portion de la couche de grille flottante (28) adjacente au film isolant de séparation (24) est formée avec une face convexe, lisse.

2. Un procédé selon la revendication 1, caractérisé en ce que ledit film résistant à l'oxydation à motif est formé de façon qu'il se trouve par-dessus la couche de silicium monocristallin avec un film isolant (50) entre les deux.

3. Un procédé selon la revendication 1 ou 2, caractérisé en ce qu'une impureté est dopée fortement dans la couche de silicium non monocristallin avant que la couche de silicium non monocristallin soit sélectivement oxydée.

4. Un procédé selon la revendication 3, caractérisé en ce que ladite impureté est dopée avec un niveau de concentration élevée de phosphore de l'ordre de $3 \times 10^{20}$ à $8 \times 10^{20}/cm^3$.

5. Un procédé selon l'une quelconque des revendications précédentes, caractérisé en ce que, après la formation de la couche de grille flottante (26), une grille de contrôle (28) est formée de façon qu'elle s'étende par-dessus ladite couche de grille flottante avec le film isolant (50, 22, 52) entre les deux, ladite grille de contrôle (38) étant réalisée en un métal ayant un point de fusion élevé ou en un siliciure dudit métal.

6. Un procédé selon la revendication 1, 2, 3 ou 4, caractérisé en ce que, après la formation de la couche de grille flottante, une couche de grille de contrôle (34, 36, 38) réalisée en un polycide est formée de façon qu'elle s'étendre par-dessus la couche de grille flottante avec le film isolant entre les deux.

7. Un procédé selon l'une quelconque des revendications précédentes, caractérisé en ce que, après la formation dudit film isolant de séparation (24), une partie ou la totalité de ladite couche isolante de séparation (24) est éliminée.

8. Un procédé selon la revendication 1, 2, 3 ou 4, caractérisé en ce que, avec ledit motif résistant à l'oxydation (22) laissé sur la grille flottante et avec ledit film isolant de séparation (24) laissé à l'intérieur de l'ouverture, une couche de grille de contrôle (38) est formée sur la structure résultante.

9. Un procédé selon l'une quelconque des revendications précédentes, caractérisé en ce que ledit film résistant à l'oxydation à motif (22) est un film de nitrure de silicium.

10. Un procédé selon l'une quelconque des revendications précédentes, caractérisé en ce que ladite couche de silicium non monocristallin est réalisée en un silicium polycristallin ou en un silicium amorphe.

# F I G. 1A

# F I G. 1B

# F I G. 1C

# F I G. 1D

1

# F I G. 1E

# F I G. 2

# F I G. 3

# FIG. 4

# F I G. 5A

# F I G. 5B

# F I G. 5C

# F I G. 5D

4

F I G. 5E

F I G. 6

# F I G. 7

# F I G. 8A

# F I G. 8B

# F I G. 8C

# F I G. 8D

# F I G. 8E

# F I G. 9

# F I G. 10